# EUROPEAN PATENT APPLICATION

(11) **EP 4 764 539 A1**
(43) Date of publication of application: **24.06.2026**
(21) Application number: 24901017.4
(22) Date of filing: 03.12.2024
(51) Int. Cl.: G01R 31/389, G01R 23/16, G01R 23/00, G01R 19/00, G01R 19/10

(54) **BATTERY DIAGNOSIS DEVICE AND OPERATION METHOD THEREOF**

(30) Priority: 08.12.2023 KR 20230178063
(71) Applicant: LG Energy Solution, Ltd., Seoul 07335 (KR)
(72) Inventor: LEE, Jeong Hwan, Daejeon 34122 (KR); PARK, Jae Dong, Daejeon 34122 (KR); LEE, Gyu Yeol, Daejeon 34122 (KR); YOON, Ho Byung, Daejeon 34122 (KR); LEE, Gyu Rin, Daejeon 34122 (KR)
(74) Representative: Plasseraud IP
(86) International application number: PCT/KR2024/019556
(87) International publication number: WO 2025/121831

(57) **Abstract**

A battery diagnosis apparatus according to an embodiment disclosed herein includes a pulse application unit configured to apply a current pulse to a battery and a controller configured to obtain a first voltage corresponding to the current pulse, calculate a frequency-specific impedance of the battery through Fourier transformation based on the current pulse and the first voltage, and diagnose whether an abnormal battery cell is included in the battery based on first information of the battery, related to the frequency-specific impedance of the battery.

## Description

### CROSS-REFERENCE TO RELATED APPLICATION

This application claims priority to and the benefit of Korean Patent Application No. 10-2023-0178063 filed in the Korean Intellectual Property Office on December 8, 2023, the entire content of which is incorporated herein by reference.

### TECHNICAL FIELD

Embodiments disclosed herein relate to a battery diagnosis apparatus and an operating method thereof.

### TITLE OF INVENTION

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

A battery is managed through a battery management system (BMS). The BMS measures or predicts a state of the battery and thereby diagnoses whether the battery is abnormal. A behavior of the battery may be changed variously for a state of charge (SOC), a state of health (SOH), etc., making it difficult to accurately derive abnormal diagnosis.

### TITLE OF INVENTION

Embodiments disclosed herein aim to provide a battery diagnosis apparatus and an operating method thereof in which a frequency-specific impedance of cells in a battery may be calculated and the battery may be diagnosed based on the calculated impedance.

Embodiments disclosed herein aim to provide a battery diagnosis apparatus and an operating method thereof in which a frequency-specific impedance of a battery may be calculated based on a response of a pulse applied to the battery.

Technical problems of the embodiments disclosed herein are not limited to the above-described technical problems, and other unmentioned technical problems would be clearly understood by one of ordinary skill in the art from the following description.

### TECHNICAL SOLUTION

A battery diagnosis apparatus according to an embodiment disclosed herein includes a pulse application unit configured to apply a current pulse to a battery and a controller configured to obtain a first voltage corresponding to the current pulse, calculate a frequency-specific impedance of the battery through Fourier transformation based on the current pulse and the first voltage, and diagnose whether an abnormal battery cell is included in the battery based on first information of the battery, related to the frequency-specific impedance of the battery.

In an embodiment, the pulse application unit may be configured to apply at least any one of a charging current pulse and a discharging current pulse to the battery.

In an embodiment, the pulse application unit may be further configured to alternately apply at least two signals among a charging current pulse, a rest period, and a discharging current pulse to the battery.

In an embodiment, the first information may include at least any one of a real part of the frequency-specific impedance, an imaginary part of the frequency-specific impedance, a magnitude of the frequency-specific impedance, or a phase of the frequency-specific impedance.

In an embodiment, the controller may be further configured to calculate a first difference based on a difference between first information at a first frequency and first information at a plurality of frequencies different from the first frequency and diagnose whether an abnormal battery cell is included in the battery, based on the first difference at the plurality of frequencies.

In an embodiment, the controller may be further configured to calculate a first difference for each of the plurality of battery cells included in the battery, calculate an average of the first difference for each of the plurality of battery cells, and diagnose abnormality of the battery based on an average of the first difference and the first difference for each of the plurality of battery cells.

In an embodiment, the controller may be further configured to calculate a deviation between the average of the first difference and the first difference for each of the plurality of battery cells and diagnose that an abnormal battery cell is included in the battery when the deviation is greater than or equal to a preset value.

In an embodiment, the controller may be further configured to calculate the deviation in a set frequency range.

In an embodiment, the first frequency may include a least frequency among frequencies at which an impedance is calculated.

In an embodiment, the first frequency may include a greatest frequency among frequencies at which an impedance is calculated.

An operating method of a battery diagnosis apparatus according to an embodiment disclosed herein includes applying a current pulse to a battery, obtaining a first voltage corresponding to the current pulse, calculating a frequency-specific impedance of the battery through Fourier transformation based on the current pulse and the first voltage, and diagnosing whether an abnormal battery cell is included in the battery based on first information of the battery, related to the frequency-specific impedance of the battery.

In an embodiment, the applying of the current pulse to the battery may include applying at least any one of a charging current pulse and a discharging current pulse to the battery.

In an embodiment, the applying of the current pulse to the battery may include alternately applying at least two signals among a charging current pulse, a rest period, and a discharging current pulse to the battery.

In an embodiment, the first information may include at least any one of a real part of the frequency-specific impedance, an imaginary part of the frequency-specific impedance, a magnitude of the frequency-specific impedance, or a phase of the frequency-specific impedance.

In an embodiment, the diagnosing of whether the abnormal battery cell is included in the battery based on first information of the battery, related to the frequency-specific impedance of the battery may include calculating a first difference based on a difference between first information at a first frequency and first information at a plurality of frequencies different from the first frequency and diagnosing whether an abnormal battery cell is included in the battery, based on the first difference at the plurality of frequencies.

In an embodiment, the diagnosing of whether the abnormal battery cell is included in the battery based on first information of the battery, related to the frequency-specific impedance of the battery may include calculating a first difference for each of the plurality of battery cells included in the battery, calculating an average of the first difference for each of the plurality of battery cells, and diagnosing abnormality of the battery based on an average of the first difference and the first difference for each of the plurality of battery cells.

In an embodiment, the diagnosing of abnormality of the battery based on the average of the first difference and the first difference for each of the plurality of battery cells may include calculating a deviation between the average of the first difference and the first difference for each of the plurality of battery cells and diagnosing that an abnormal battery cell is included in the battery when the deviation is greater than or equal to a preset value.

In an embodiment, the calculating of the deviation between the average of the first difference and the first difference for each of the plurality of battery cells may include calculating the deviation in a set frequency range.

In an embodiment, the first frequency may include a greatest frequency among frequencies at which an impedance is calculated.

In an embodiment, the first frequency may include a greatest frequency among frequencies at which an impedance is calculated.

### ADVANTAGEOUS EFFECTS

A battery diagnosis apparatus and an operating method thereof according to an embodiment disclosed herein may precisely diagnose a battery.

The battery diagnosis apparatus and the operating method thereof according to an embodiment disclosed herein may calculate a frequency-specific impedance through Fourier transformation and diagnose a battery based on the calculated frequency-specific impedance.

The battery diagnosis apparatus and the operating method thereof according to an embodiment disclosed herein may determine whether there is a defective cell in a battery.

In addition, various effects identified directly or indirectly through this document may be provided.

### DESCRIPTION OF DRAWINGS

FIG. 1 is a block diagram of a battery diagnosis apparatus according to an embodiment disclosed herein.
FIG. 2 shows an example in which a battery diagnosis apparatus applies a pulse, according to an embodiment disclosed herein.
FIG. 3 shows an example of a result of calculating a frequency-specific impedance by a battery diagnosis apparatus according to an embodiment disclosed herein.
FIG. 4 shows an example of determining whether there is an abnormal battery cell in a battery by a battery diagnosis apparatus according to an embodiment disclosed herein.
FIG. 5 is a view showing an operating method of a battery diagnosis apparatus according to an embodiment disclosed herein.
FIGS. 6 to 8 are flowcharts showing in detail an operating method of a battery diagnosis apparatus according to an embodiment disclosed herein.
FIG. 9 is a block diagram showing a hardware configuration of a computing system for performing an operating method of a battery diagnosis apparatus, according to an embodiment disclosed herein.

### MODE FOR INVENTION

Hereinafter, embodiments disclosed herein will be described in detail through exemplary drawings. In adding reference numerals to components of each drawing, it should be noted that the same components have the same numerals as much as possible even though they are displayed on different drawings. Moreover, in describing the embodiments disclosed herein, when it is determined that a detailed description of a related known configuration or function interferes with understanding of the embodiment disclosed herein, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. The terms defined in a generally used dictionary should be interpreted as having the same meanings as the contextual meanings of the relevant technology and should not be interpreted as having ideal or exaggerated meanings unless they are clearly defined in the present application.

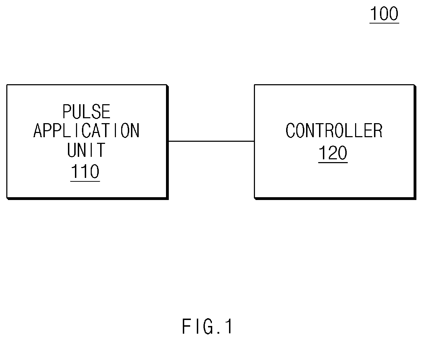

FIG. 1 shows a battery diagnosis apparatus according to an embodiment disclosed herein.

Referring to FIG. 1, a battery diagnosis apparatus 100 according to an embodiment disclosed herein may include a pulse application unit 110 and a controller 120.

The battery diagnosis apparatus 100 may be one of various electronic devices for managing, diagnosing, or testing a battery. For example, the battery diagnosis apparatus 100 may be a pulse analyzer. The pulse analyzer may be a device for diagnosing whether a battery is abnormal based on a response of a pulse applied to the battery. The pulse analyzer may be included in a BMS in a vehicle or may be implemented as a separate external device distinguished from the BMS in the vehicle. The pulse analyzer may further include a pulse generator for pulse generation, but this is merely an example, and the pulse generator may be implemented as a separate external device. In the latter case, the battery diagnosis apparatus 100 may receive a response to a pulse applied to the battery by the pulse generator from the battery and diagnose whether the battery is abnormal based on the response.

According to another embodiment, the battery diagnosis apparatus 100 may be included in an apparatus for a charging/discharging test such as a server, a cloud server, or a charging/discharging cycler or may be included in various devices for diagnosing or testing the battery.

The pulse application unit 110 may apply a current pulse to the battery. For example, the pulse application unit 110 may apply a plurality of current pulses to the battery.

According to an embodiment, the pulse application unit 110 may apply at least any one of a charging pulse and a discharging pulse to the battery. In another example, the pulse application unit 110 may alternately apply the charging pulse and the discharging pulse to the battery.

According to an embodiment, the pulse application unit 110 may alternately apply the charging pulse and the discharging pulse to the battery and may not set a rest period between the charging pulse and the discharging pulse. According to another embodiment, the pulse application unit 110 may set the rest period between the charging pulse and the discharging pulse while alternately applying the charging pulse and the discharging pulse to the battery.

According to an embodiment, the pulse application unit 110 may continuously apply the charging pulse to the battery. For example, the pulse application unit 110 may apply the charging pulse to the battery, set the rest period, and apply the charging pulse again, thereby continuously applying the charging pulse during a set period.

According to an embodiment, the pulse application unit 110 may continuously apply the discharging pulse to the battery. For example, the pulse application unit 110 may apply the discharging pulse to the battery, set the rest period, and apply the discharging pulse again, thereby continuously applying the discharging pulse during a set period.

According to an embodiment, the pulse application unit 110 may alternately apply, to the battery, the charging pulse, the rest period, and the discharging pulse that are set according to specific conditions. For example, the pulse application unit 110 apply a pulse to the battery in such a way to apply a charging pulse of 0.1 second, to have a rest period of 0.1 second, to apply a discharging pulse of 0.1 second, and to repeat the foregoing process. However, the present disclosure is not limited thereto, and the pulse application unit 110 may apply a pulse to the battery by determining an application time of the charging pulse, whether to apply the charging pulse, whether to have the rest period, a rest time, an application time of the discharging pulse, and whether to apply the discharging pulse.

According to an embodiment, the pulse application unit 110 may alternatively apply the charging pulse and the discharging pulse a plurality of times. For example, the pulse application unit 110 may alternatively apply the charging pulse and the discharging pulse three to ten times. However, the present disclosure is not limited thereto, and the pulse application unit 110 may alternately apply the charging pulse and the discharging pulse n times (n is a natural number).

According to an embodiment, the pulse application unit 110 may apply the charging pulse and the discharging pulse as current.

Such a pulse application unit 110 may receive the pulse generated by an external device from the external device and apply the received pulse to the battery, and may also generate the pulse and apply the generated pulse to the battery based on control of the controller 120.

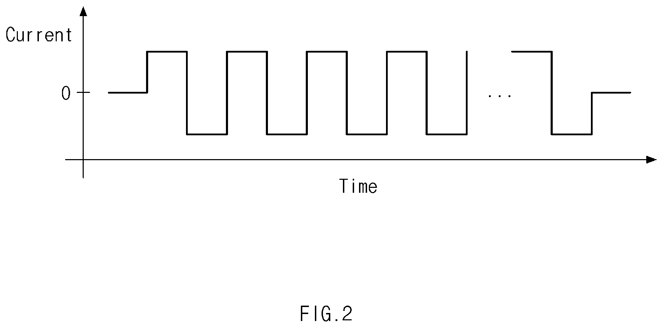

FIG. 2 shows an example in which a battery diagnosis apparatus applies a pulse, according to an embodiment disclosed herein.

Referring to FIG. 2, the pulse application unit 110 of the battery diagnosis apparatus 100 may apply a pulse to the battery. While the pulse application unit 110 alternately applies the charging pulse and the discharging pulse in FIG. 2, the present disclosure is not limited thereto.

According to an embodiment, the pulse application unit 110 may apply various pulses to the battery through repetition of the charging pulse and the discharging pulse, repetition of the charging pulse and the rest period, repetition of the discharging pulse and the rest period, repetition of the charging pulse, the rest period, and the discharging pulse, etc.

Referring back to FIG. 1, the controller 120 may obtain a first voltage corresponding to a current pulse. For example, the controller 120 may obtain a voltage corresponding to any one of the charging pulse or the discharging pulse of the current pulse as the first voltage.

According to an embodiment, when the pulse application unit 110 applies a plurality of current pulses, the controller 120 may obtain the first voltage corresponding to one or all of the plurality of current pulses. In another example, the controller 120 may obtain a voltage response corresponding to each of the plurality of current pulses and obtain all or some of the obtained voltage responses as the first voltages. For example, the controller 120 may obtain a voltage corresponding to a discharging pulse among the plurality of current pulses as the first voltage, obtain a voltage corresponding to a charging pulse among the plurality of current pulses as the first voltage, or obtain a voltage corresponding to each of the charging pulse and the discharging pulse included in the plurality of current pulses as the first voltage.

According to an embodiment, the controller 120 may calculate, as an average voltage, an average of the first voltage corresponding to at least one current pulse. For example, the controller 120 may extract at least any one current pulse from among the plurality of current pulses according to a criterion and calculate an average voltage as an average of the first voltage corresponding to the extracted at least one current pulse. In another embodiment, the controller 120 may calculate, as an average voltage, an average of the first voltages corresponding to all or some current pulses for each of the plurality of current pulses. According to an embodiment, the controller 120 may calculate an average voltage by calculating an average of the first voltages corresponding to current pulses having low noises among the plurality of current pulses.

According to an embodiment, when the charging pulse and the discharging pulse are repeated 5 times, the controller 120 may obtain, as 5 first voltages corresponding to 5 discharging pulses, voltage responses corresponding to the discharging pulse repeated 5 times or calculate, as an average voltage, an average of all or some of the 5 first voltages. That is, the controller 120 may obtain the first voltage(s) corresponding to one current pulse or a plurality of current pulses and diagnose the battery based on an average voltage of the obtained first voltage(s). However, an operation of calculating the average voltage of the first voltage(s) corresponding to the plurality of current pulses may be omitted or performed as an operation for removing noise.

The controller 120 may calculate a frequency-specific impedance of the battery through Fourier transformation based on the current pulse and the first voltage. For example, Fourier transformation may include fast Fourier transformation (FFT) or discrete Fourier transformation (DFT).

According to an embodiment, the controller 120 may perform Fourier transformation on a current pulse, perform Fourier transformation on a first voltage, and divide the Fourier-transformed first voltage into the Fourier-transformed current pulse to calculate a Fourier-transformed impedance. The controller 120 may calculate a frequency-specific impedance based on the Fourier-transformed impedance.

The controller 120 may diagnose whether an abnormal battery cell is included in the battery, based on first information of the first battery, related to the specific-frequency impedance of the battery. For example, the first information may include at least any one of a real part of the frequency-specific impedance, an imaginary part of the frequency-specific impedance, a magnitude of the frequency-specific impedance, or a phase of the frequency-specific impedance. According to an embodiment, the controller 120 may diagnose whether the abnormal battery cell is included in the battery, based on the real part of the frequency-specific impedance.

The controller 120 may calculate a first difference based on a difference between the first information at a first frequency and first information at a plurality of frequencies different from the first frequency. For example, the first frequency may be the least frequency among frequencies at which the impedance is calculated. In another example, the first frequency may be the greatest frequency among frequencies at which the impedance is calculated. That is, the first frequency may be a reference frequency among frequencies at which the impedance is calculated.

The controller 120 may diagnose whether the abnormal battery cell is included in the battery, based on the first difference at a plurality of frequencies. For example, the controller 120 may calculate a difference between a real part of the impedance at the first frequency and a real part of the impedance at the plurality of frequencies and diagnose whether the abnormal battery cell is included based on the calculated difference.

According to an embodiment, the battery may include a plurality of battery cells. The controller 120 may calculate the first difference for each of the plurality of battery cells included in the battery and calculate an average of the first difference for each of the plurality of battery cells. The controller 120 may also diagnose abnormality of the battery based on the average of the first difference and the first difference for each of the plurality of battery cells. For example, the controller 120 may also diagnose whether the abnormal battery cell is included in the battery based on the average of the first difference and the first difference for each of the plurality of battery cells.

According to an embodiment, the controller 120 may calculate a deviation between the average of the first difference and the first difference for each of the plurality of battery cells, and diagnose that the abnormal battery cell is included in the battery when the deviation is greater than or equal to a preset value.

According to an embodiment, the controller 120 may calculate the deviation in a set frequency range to use the same for diagnosis. For example, the set frequency range may include a range from 0.5 Hz to 50 Hz.

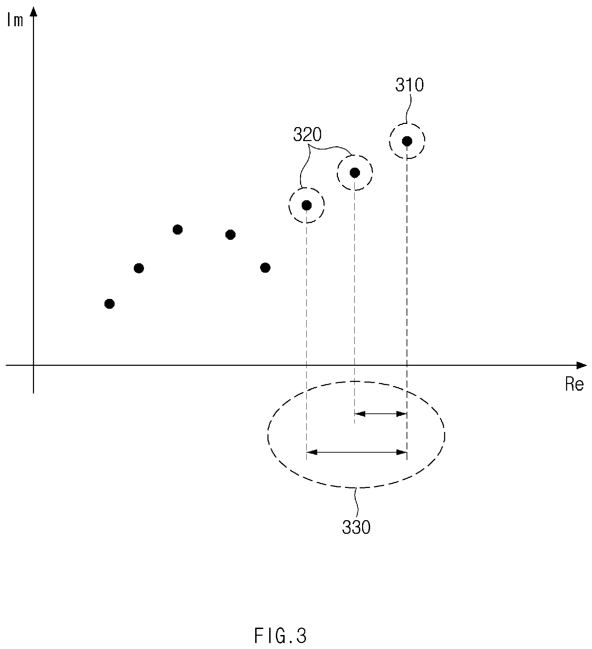

FIG. 3 shows an example of a result of calculating a frequency-specific impedance by a battery diagnosis apparatus according to an embodiment disclosed herein.

Referring to FIG. 3, the battery diagnosis apparatus 100 may calculate a frequency-specific impedance of a battery cell included in the battery to identify a Nyquist plot. However, a feature of identifying the Nyquist plot is not essential, and the battery diagnosis apparatus 100 may identify a real part and an imaginary part of a frequency-specific impedance of the battery cell.

The controller 120 of the battery diagnosis apparatus 100 may identify an impedance 310 of the battery cell at the first frequency. While it is shown in FIG. 3 that the least frequency among frequencies at which the impedance is calculated is the first frequency, the present disclosure is not limited thereto. The controller 120 may identify an impedance 320 of the battery cell at the plurality of frequencies different from the first frequency.

The controller 120 may calculate a first difference 330 between first information related to the impedance of the battery cell at the first frequency and first information related to the impedance of the battery cell at the plurality of frequencies different from the first frequency. For example, the controller 120 may calculate the first difference for each of the plurality of frequencies. While it is shown in FIG. 3 that the first information includes the real part of the impedance, the present disclosure is not limited thereto. Although it is shown in FIG. 3 that the first difference is calculated for two frequencies, the present disclosure is not limited thereto and the controller 120 may calculate the first difference for all of the frequencies at which the impedance is calculated.

While a frequency-specific impedance of one battery cell is shown and a first difference for a plurality of frequencies of one battery cell is calculated in FIG. 3, the present disclosure is not limited thereto and the controller 120 may calculate a frequency-specific impedance for each of the plurality of battery cells and calculate a first difference at the plurality of frequencies for each of the plurality of battery cells.

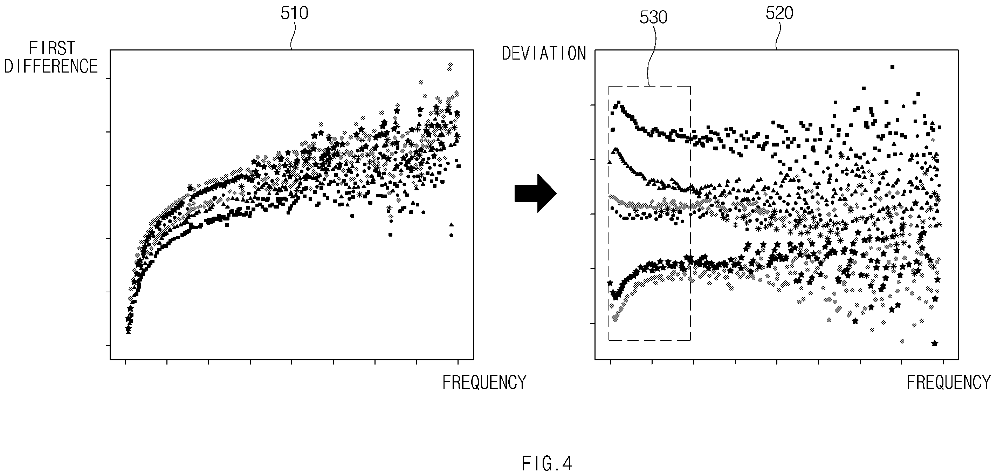

FIG. 4 shows an example of determining whether there is an abnormal battery cell in a battery by a battery diagnosis apparatus according to an embodiment disclosed herein.

Referring to FIG. 4, the controller 120 of the battery diagnosis apparatus 100 according to an embodiment disclosed herein may calculate a first difference 510 at a frequency for each of a plurality of battery cells.

The controller 120 may calculate an average of the first difference for each of the plurality of battery cells and calculate a deviation 520 between the average of the first difference and the first difference for each of the plurality of battery cells. For example, the controller 120 may calculate the average of the first difference for each frequency at which the first difference 510 at the frequency of each of the plurality of battery cells is calculated, and calculate the deviation between the average of the first difference and the first difference for each battery cell for each calculated frequency. In another example, the deviation may be calculated based on the difference, may be calculated based on a standard deviation through normal distribution, or may be calculated in various manners such as a root mean square (RMS), a least square mean (LSM), etc.

The controller 120 may determine whether the abnormal battery cell is included among the plurality of battery cells based on the deviation 520 of the first difference for each of the plurality of battery cells. That is, the controller 120 may determine whether the abnormal battery cell is included in the battery based on the deviation 520 of the first difference for each of the plurality of battery cells. According to an embodiment, the controller 120 may calculate the deviation in a set frequency range 530 and diagnose whether the abnormal battery cell is included in the battery.

Thus, the battery diagnosis apparatus 100 according to an embodiment disclosed herein may precisely diagnose the battery.

The battery diagnosis apparatus 100 according to an embodiment disclosed herein may calculate a frequency-specific impedance through Fourier transformation and diagnose the battery based on the calculated frequency-specific impedance.

The battery diagnosis apparatus 100 according to an embodiment disclosed herein may determine whether there is a defective cell in the battery.

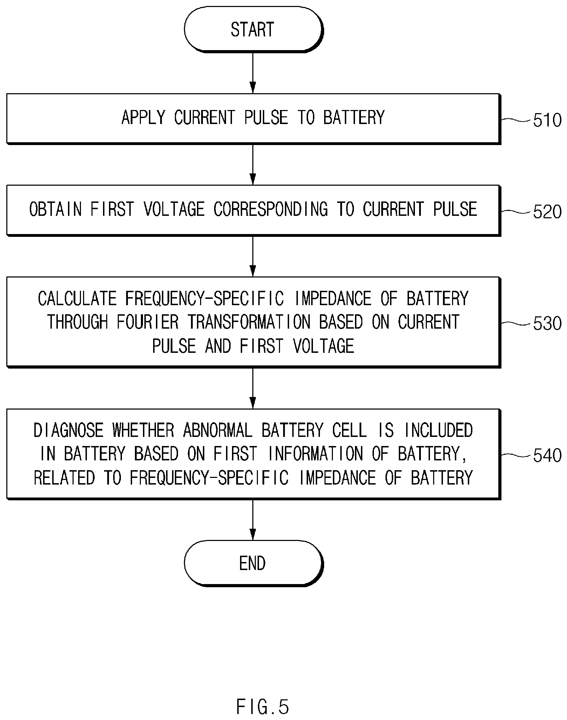

FIG. 5 is a view showing an operating method of a battery diagnosis apparatus according to an embodiment disclosed herein. According to an embodiment, operations shown in FIG. 5 may be performed by the battery diagnosis apparatus 100 of FIG. 1.

Referring to FIG. 5, in operation 510, the pulse application unit 110 may apply a current pulse to the battery. For example, the pulse application unit 110 may apply a plurality of current pulses to the battery.

According to an embodiment, the pulse application unit 110 may apply at least any one of a charging pulse and a discharging pulse to the battery. In another example, the pulse application unit 110 may alternately apply the charging pulse and the discharging pulse to the battery.

According to an embodiment, the pulse application unit 110 may alternately apply the charging pulse and the discharging pulse to the battery and may not set a rest period between the charging pulse and the discharging pulse. According to another embodiment, the pulse application unit 110 may alternately apply the charging pulse and the discharging pulse to the battery and may set the rest period therebetween.

According to an embodiment, the pulse application unit 110 may continuously apply the charging pulse to the battery. For example, the pulse application unit 110 may apply the charging pulse to the battery, set the rest period, and apply the charging pulse again, thereby continuously applying the charging pulse during a set period.

According to an embodiment, the pulse application unit 110 may continuously apply the discharging pulse to the battery. For example, the pulse application unit 110 may apply the discharging pulse to the battery, set the rest period, and apply the discharging pulse again, thereby continuously applying the discharging pulse during a set period.

According to an embodiment, the pulse application unit 110 may alternately apply, to the battery, the charging pulse, the rest period, and the discharging pulse that are set according to specific conditions. For example, the pulse application unit 110 apply a pulse to the battery in such a way to apply a charging pulse of 0.1 second, to have a rest period of 0.1 second, to apply a discharging pulse of 0.1 second, and to repeat the foregoing process. However, the present disclosure is not limited thereto, and the pulse application unit 110 may apply a pulse to the battery by determining an application time of the charging pulse, whether to apply the charging pulse, whether to have the rest period, a rest period time, an application time of the discharging pulse, and whether to apply the discharging pulse.

According to an embodiment, the pulse application unit 110 may alternatively apply the charging pulse and the discharging pulse a plurality of times. For example, the pulse application unit 110 may alternatively apply the charging pulse and the discharging pulse three to ten times. However, the present disclosure is not limited thereto, and the pulse application unit 110 may alternately apply the charging pulse and the discharging pulse n times (n is a natural number).

According to an embodiment, the pulse application unit 110 may apply the charging pulse and the discharging pulse as current.

In operation 520, the controller 120 may obtain a first voltage corresponding to a current pulse. For example, the controller 120 may obtain a voltage corresponding to any one of the charging pulse or the discharging pulse of the current pulse as the first voltage.

According to an embodiment, when the pulse application unit 110 applies a plurality of current pulses, the controller 120 may obtain the first voltage corresponding to one or all of the plurality of current pulses. In another example, the controller 120 may obtain a voltage response corresponding to each of the plurality of current pulses and obtain all or some of the obtained voltage responses as the first voltages. For example, the controller 120 may obtain a voltage corresponding to a discharging pulse among the plurality of current pulses as the first voltage, obtain a voltage corresponding to a charging pulse among the plurality of current pulses as the first voltage, or obtain a voltage corresponding to each of the charging pulse and the discharging pulse included in the plurality of current pulses as the first voltage.

According to an embodiment, the controller 120 may calculate, as an average voltage, an average of the first voltage corresponding to at least one current pulse. For example, the controller 120 may extract at least any one current pulse from among the plurality of current pulses according to a criterion and calculate an average voltage as an average of the first voltage corresponding to the extracted at least one current pulse. In another embodiment, the controller 120 may calculate, as an average voltage, an average of the first voltages corresponding to all or some current pulses for each of the plurality of current pulses. According to an embodiment, the controller 120 may calculate an average voltage by calculating an average of the first voltages corresponding to current pulses having low noises among the plurality of current pulses.

According to an embodiment, when the charging pulse and the discharging pulse are repeated 5 times, the controller 120 may obtain, as 5 first voltages corresponding to 5 discharging pulses, voltage responses corresponding to the discharging pulse repeated 5 times or calculate, as an average voltage, an average of all or some of the 5 first voltages. That is, the controller 120 may obtain the first voltage(s) corresponding to one current pulse or a plurality of current pulses and diagnose the battery based on an average voltage of the obtained first voltage(s). However, an operation of calculating the average voltage of the first voltage(s) corresponding to the plurality of current pulses may be omitted or performed as an operation for removing noise.

In operation 530, the controller 120 may calculate a frequency-specific impedance of the battery through Fourier transformation based on the current pulse and the first voltage. For example, Fourier transformation may include FFT or DFT.

According to an embodiment, the controller 120 may perform Fourier transformation on a current pulse, perform Fourier transformation on a first voltage, and divide the Fourier-transformed first voltage into the Fourier-transformed current pulse to calculate a Fourier-transformed impedance. The controller 120 may calculate a frequency-specific impedance based on the Fourier-transformed impedance.

In operation 540, the controller 120 may diagnose whether an abnormal battery cell is included in the battery, based on first information of the first battery, related to the specific-frequency impedance of the battery. For example, the first information may include at least any one of a real part of the frequency-specific impedance, an imaginary part of the frequency-specific impedance, a magnitude of the frequency-specific impedance, or a phase of the frequency-specific impedance. According to an embodiment, the controller 120 may diagnose whether the abnormal battery cell is included in the battery, based on the real part of the frequency-specific impedance.

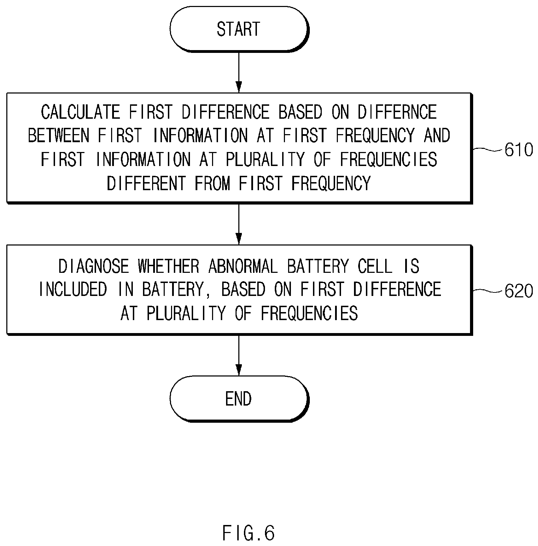

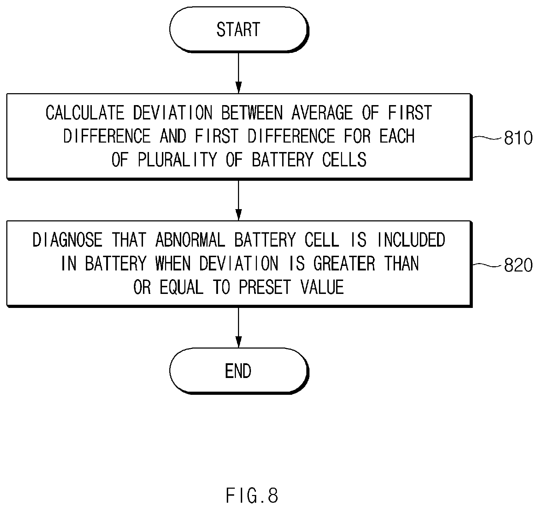

FIGS. 6 and 8 are flowcharts showing in detail an operating method of a battery diagnosis apparatus according to an embodiment disclosed herein. According to an embodiment, operations shown in FIGS. 6 to 8 may be performed by the battery diagnosis apparatus 100 of FIG. 1.

Referring to FIG. 6, in operation 610, the controller 120 may calculate the first difference based on the difference between the first information at the first frequency and the first information at the plurality of frequencies different from the first frequency. For example, the first frequency may be the least frequency among frequencies at which the impedance is calculated. In another example, the first frequency may be the greatest frequency among frequencies at which the impedance is calculated. That is, the first frequency may be a reference frequency among frequencies at which the impedance is calculated.

In operation 620, the controller 120 may diagnose whether the abnormal battery cell is included in the battery, based on the first difference at a plurality of frequencies. For example, the controller 120 may calculate a difference between a real part of the impedance at the first frequency and a real part of the impedance at the plurality of frequencies and diagnose whether the abnormal battery cell is included based on the calculated difference.

According to an embodiment, operations 610 and 620 may be included in operation 540 of FIG. 5.

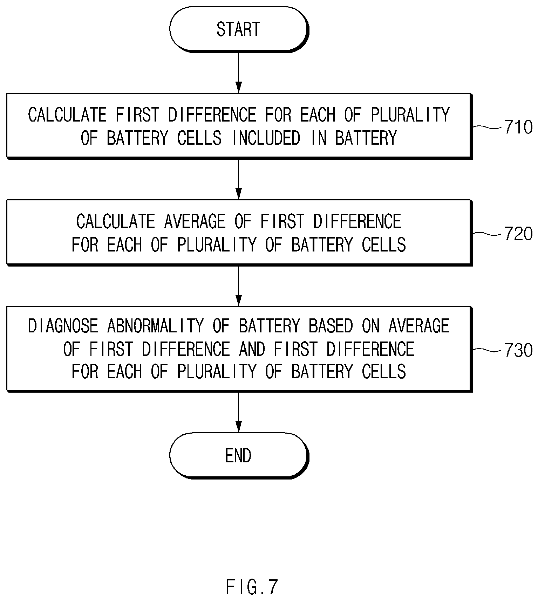

Referring to FIG. 7, in operation 710, the controller 120 may calculate the first difference for each of the plurality of battery cells included in the battery.

In operation 720, the controller 120 may calculate the average of the first difference for each of the plurality of battery cells.

In operation 730, the controller 120 may also diagnose abnormality of the battery based on the average of the first difference and the first difference for each of the plurality of battery cells.

Operations 710 to 730 may be included in operation 540 of FIG. 5. For example, the battery may include a plurality of battery cells.

Referring to FIG. 8, in operation 810, the controller 120 may calculate the deviation between the average of the first difference and the first difference for each of the plurality of battery cells.

In operation 820, the controller 120 may diagnose that the abnormal battery cell is included in the battery when the deviation is greater than or equal to a preset value.

According to an embodiment, the controller 120 may calculate the deviation in a set frequency range to use the same for diagnosis. For example, the set frequency range may include a range from 0.5 Hz to 50 Hz.

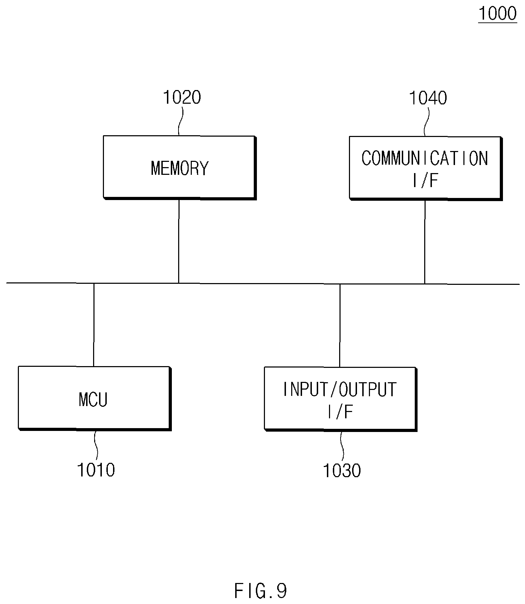

FIG. 9 is a block diagram showing a hardware configuration of a computing system for performing an operating method of a battery diagnosis apparatus, according to an embodiment disclosed herein.

Referring to FIG. 9, a computing system 1000 according to an embodiment disclosed herein may include a microcontroller unit (MCU) 1010, a memory 1020, an input/output interface (I/F) 1030, and a communication I/F 1040.

The MCU 1010 may be a processor that executes various programs (e.g., a pulse generation program, a voltage extraction program, an impedance calculation program, a battery diagnosis program, etc.) stored in the memory 1020, processes various information including a voltage of a battery, an impedance of the battery, presence or absence of the abnormal battery cell, etc., through these programs, and executes the above-described functions of the controller included in the battery diagnosis apparatus shown in FIG. 1.

The memory 1020 may store various programs such as a pulse generation program, a voltage extraction program, an impedance calculation program, a battery diagnosis program, etc. Moreover, the memory 1020 may store various information such as the voltage of the battery, the impedance of the battery, presence or absence of the abnormal battery cell, etc.

The memory 1020 may be provided in plural, depending on a need. The memory 1020 may be a volatile or nonvolatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., with the MCU 1010.

The communication I/F 1040, which is a component capable of transmitting and receiving various data to and from a server, may be various types of devices capable of supporting wired or wireless communication. For example, the battery diagnosis apparatus may transmit and receive various information including various information such as the voltage of the battery, the impedance of the battery, presence or absence of the abnormal battery cell, etc., from an external server separately provided through the communication I/F 1040.

As such, a computer program according to an embodiment disclosed herein may be recorded in the memory 1020 and processed by the MCU 1010, thus being implemented as a module that performs functions shown in FIG. 1.

The above description is merely illustrative of the technical idea disclosed herein, and various modifications and variations will be possible without departing from the essential characteristics of the embodiments disclosed herein by those of ordinary skill in the art to which the embodiments disclosed herein pertains.

Therefore, the embodiments disclosed herein are intended for description rather than limitation of the technical spirit of the embodiments disclosed herein and the scope of the technical spirit disclosed herein is not limited by these embodiments. The protection scope of the technical spirit disclosed herein should be interpreted by the following claims, and all technical spirits within the same range should be understood to be included in the range of this document.

### [EXPLANATION OF REFERENCE NUMERALS DESIGNATING THE MAJOR ELEMENTS OF THE DRAWINGS]

100: BATTERY DIAGNOSIS APPARATUS
110: PULSE APPLICATION UNIT
120: CONTROLLER
1000: COMPUTING SYSTEM
1010: MCU
1020: MEMORY
1030: INPUT/OUTPUT I/F
1040: COMMUNICATION I/F

## Claims

1. A battery diagnosis apparatus comprising:
a pulse application unit configured to apply a current pulse to a battery; and
a controller configured to:
obtain a first voltage corresponding to the current pulse;
calculate a frequency-specific impedance of the battery through Fourier transformation based on the current pulse and the first voltage; and
diagnose whether an abnormal battery cell is included in the battery based on first information of the battery, related to the frequency-specific impedance of the battery.

2. The battery diagnosis apparatus of claim 1, wherein the pulse application unit is further configured to apply at least any one of a charging current pulse and a discharging current pulse to the battery.

3. The battery diagnosis apparatus of claim 1, wherein the pulse application unit is further configured to alternately apply at least two signals among a charging current pulse, a rest period, and a discharging current pulse to the battery.

4. The battery diagnosis apparatus of claim 1, wherein the first information comprises at least any one of a real part of the frequency-specific impedance, an imaginary part of the frequency-specific impedance, a magnitude of the frequency-specific impedance, or a phase of the frequency-specific impedance.

5. The battery diagnosis apparatus of claim 1, wherein the controller is further configured to:
calculate a first difference based on a difference between first information at a first frequency and first information at a plurality of frequencies different from the first frequency; and
diagnose whether an abnormal battery cell is included in the battery, based on the first difference at the plurality of frequencies.

6. The battery diagnosis apparatus of claim 5, wherein the controller is further configured to:
calculate a first difference for each of the plurality of battery cells included in the battery;
calculate an average of the first difference for each of the plurality of battery cells; and
diagnose abnormality of the battery based on an average of the first difference and the first difference for each of the plurality of battery cells.

7. The battery diagnosis apparatus of claim 6, wherein the controller is further configured to:
calculate a deviation between the average of the first difference and the first difference for each of the plurality of battery cells; and
diagnose that an abnormal battery cell is included in the battery when the deviation is greater than or equal to a preset value.

8. The battery diagnosis apparatus of claim 7, wherein the controller is further configured to calculate the deviation in a set frequency range.

9. The battery diagnosis apparatus of claim 5, wherein the first frequency comprises a least frequency among frequencies at which an impedance is calculated.

10. The battery diagnosis apparatus of claim 5, wherein the first frequency comprises a greatest frequency among frequencies at which an impedance is calculated.

11. An operating method of a battery diagnosis apparatus, the operating method comprising:
applying a current pulse to a battery;
obtaining a first voltage corresponding to the current pulse;
calculating a frequency-specific impedance of the battery through Fourier transformation based on the current pulse and the first voltage; and
diagnosing whether an abnormal battery cell is included in the battery based on first information of the battery, related to the frequency-specific impedance of the battery.

12. The operating method of claim 11, wherein the applying of the current pulse to the battery comprises applying at least any one of a charging current pulse and a discharging current pulse to the battery.

13. The operating method of claim 11, wherein the applying of the current pulse to the battery comprises alternately applying at least two signals among a charging current pulse, a rest period, and a discharging current pulse to the battery.

14. The operating method of claim 11, wherein the first information comprises at least any one of a real part of the frequency-specific impedance, an imaginary part of the frequency-specific impedance, a magnitude of the frequency-specific impedance, or a phase of the frequency-specific impedance.

15. The operating method of claim 11, wherein the diagnosing of whether the abnormal battery cell is included in the battery based on first information of the battery, related to the frequency-specific impedance of the battery comprises:
calculating a first difference based on a difference between first information at a first frequency and first information at a plurality of frequencies different from the first frequency; and
diagnosing whether an abnormal battery cell is included in the battery, based on the first difference at the plurality of frequencies.

16. The operating method of claim 15, wherein the diagnosing of whether the abnormal battery cell is included in the battery based on first information of the battery, related to the frequency-specific impedance of the battery comprises:
calculating a first difference for each of the plurality of battery cells included in the battery;
calculating an average of the first difference for each of the plurality of battery cells; and
diagnosing abnormality of the battery based on an average of the first difference and the first difference for each of the plurality of battery cells.

17. The operating method of claim 16, wherein the diagnosing of abnormality of the battery based on the average of the first difference and the first difference for each of the plurality of battery cells comprises:
calculating a deviation between the average of the first difference and the first difference for each of the plurality of battery cells; and
diagnosing that an abnormal battery cell is included in the battery when the deviation is greater than or equal to a preset value.

18. The operating method of claim 17, wherein the calculating of the deviation between the average of the first difference and the first difference for each of the plurality of battery cells comprises calculating the deviation in a set frequency range.

19. The operating method of claim 15, wherein the first frequency comprises a greatest frequency among frequencies at which an impedance is calculated.

20. The operating method of claim 15, wherein the first frequency comprises a greatest frequency among frequencies at which an impedance is calculated.
